# DEMANDE DE BREVET EUROPEEN

(11) **EP 3 943 639 A1**
(43) Date de publication de la demande: **26.01.2022**
(21) Numéro de dépôt: 21187013.4
(22) Date de dépôt: 21.07.2021
(51) Int. Cl.: C23C 16/458, C23C 16/509, H01J 37/32, H01L 21/673, H01L 21/677

(54) **DISPOSITIF DE DEPOT CHIMIQUE EN PHASE VAPEUR ASSISTE PAR PLASMA PERMETTANT UN DEPOT SUR LES BORDS DE PLAQUE**

(30) Priorité: 22.07.2020 FR 2007697
(71) Demandeur: Commissariat à l'énergie atomique et aux énergies alternatives, 75015 Paris (FR)
(72) Inventeur: MONNA, Rémi, 38054 GRENOBLE CEDEX 09 (FR); DESRUES, Thibaut, 38054 GRENOBLE CEDEX 09 (FR); VACHEZ, Alexandre, 38054 GRENOBLE CEDEX 09 (FR)
(74) Mandataire: Brevalex

(57) **Abrégé**

Dispositif de dépôt chimique en phase vapeur assisté par plasma sur des bords de plaques, comportant une enceinte (2) munie d'une ouverture, une porte (6)configurée pour fermer l'ouverture, des moyens (8.1) d'alimentation en gaz et des moyens d'évacuation (8.2) connectés à l'enceinte, un générateur électrique (8), une structure de suspension (S) d'au moins un premier empilement de plusieurs plaques à l'intérieur de l'enceinte, ladite structure (S) étant configurée pour que les plaques (P) soient alignées les unes par rapport aux autres, une circuit de connexion du premier empilement de plaques à une borne du générateur (8) de sorte à former une première électrode, le dispositif comportant au moins une deuxième électrode (56) disposée en regard d'un face du premier empilement et connectée à l'autre borne du générateur (8).

## Description

### DOMAINE TECHNIQUE ET ÉTAT DE LA TECHNIQUE ANTÉRIEURE

La présente invention se rapporte à un dispositif de dépôt chimique en phase vapeur assisté par plasma permettant un dépôt sur les bords de plaques.

Le dépôt chimique en phase vapeur assisté par plasma ou PECVD (pour Plasma-Enhanced Chemical Vapor Deposition en terminologie anglo-saxonne) est un procédé utilisé pour déposer des couches minces sur un substrat à partir d'un état gazeux.

Ce dépôt est par exemple mis en œuvre dans le domaine de la fabrication des cellules photovoltaïques pour le dépôt de couches diélectriques sur un substrat, par exemple en silicium, pour réaliser une passivation des surfaces.

Le procédé de dépôt chimique en phase vapeur assisté par plasma se déroule de la manière suivante. Des réactions chimiques ont lieu après la formation d'un plasma à partir de gaz. Par exemple, le plasma est créé à partir d'un ou plusieurs gaz en lui ou en leur appliquant une excitation par décharge électrique générée à partir de sources radiofréquences (40 kHz à 440 kHz).

Par exemple, une excitation par décharge capacitive est réalisée en appliquant un courant alternatif ou radiofréquence entre deux électrodes. Le gaz étant injecté par le haut du tube, des extinctions et allumages du plasma dans le temps permettent d'obtenir une bonne homogénéité du dépôt le long du tube. Les excitations à basse fréquence (40 kHz à 440 kHz) nécessitent plusieurs centaines de volts pour maintenir la décharge. Ces tensions importantes conduisent à un bombardement ionique à haute énergie des surfaces. La pression de travail est comprise entre 100 mTorrs et 2000 mTorrs.

Dans le cas de la fabrication des cellules photovoltaïques en silicium, le dépôt par plasma est utilisé pour réaliser les passivations des surfaces avant et arrière ainsi que les couches antireflets.

Une part de plus en plus importante de cellules photovoltaïques de grandes dimensions est découpée avant la mise en module, i.e. la connexion électrique des cellules en série et leur mise sous verre.

Une telle découpe en demi-cellule devrait permettre de diminuer de moitié le courant généré, et ainsi diminuer la résistance série dans le module photovoltaïque. Or, il résulte de cette découpe une perte de passivation des flancs de cellules, ce qui a pour effet de faire baisser le courant par unité de surface, i.e. une diminution supérieure à la moitié du courant, ainsi que la tension des cellules photovoltaïques.

Un dépôt sur une face et les flancs des substrats a lieu. Or ce principe ne peut être utilisé pour effectuer une passivation des flancs des cellules découpées, sinon un nouveau dépôt de la face aurait lieu, ce qui aurait pour effet de réduire la réflectivité.

On souhaite donc pouvoir disposer d'un dispositif de dépôt PECVD permettant un dépôt sur les flancs des substrats uniquement.

### EXPOSÉ DE L'INVENTION

C'est par conséquent un but de la présente invention d'offrir un dispositif de dépôt chimique en phase vapeur assisté par plasma permettant un dépôt sur les flancs uniquement d'une pluralité de substrats, et plus généralement sur un ou des bords uniquement d'une pluralité de plaques.

Le but énoncé ci-dessus est atteint par un dispositif de dépôt chimique en phase vapeur assisté par plasma ou PECVD comportant une enceinte configurée pour réaliser un dépôt PECVD, une structure de suspension des plaques dans l'enceinte, configurée de telle sorte que les plaques soient superposées les unes sur les autres et alignées les unes par rapport aux autres dans la direction de l'empilement. Ainsi seuls sont accessibles au matériau à déposer les bords des plaques, évitant un redépôt sur leur face. L'empilement de plaques forme une électrode et au moins une autre électrode est prévue en regard d'une partie au moins des bords des plaques, de sorte à permettre la génération d'un plasma entre ladite partie des bords et l'électrode.

Grâce à l'invention, il est possible d'effectuer un dépôt, par exemple de passivation, quasiment uniquement sur tout ou partie des flancs de substrats, de manière relativement simple.

En d'autres termes, l'invention permet d'effectuer un dépôt par PECVD sur les bords des plaques uniquement ou quasi uniquement en utilisant les plaques elles-mêmes pour masquer les faces des plaques, sur lesquelles on ne souhaite pas effectuer à nouveau un dépôt.

Dans un exemple de réalisation, la structure de suspension comporte deux supports de plaques. Lors du dépôt les deux empilements de plaques sont côte à côte et forment les deux électrodes entre lesquelles le plasma est généré.

Dans un autre exemple de réalisation le dispositif comporte deux électrodes de même polarité disposées de part et d'autre de l'empilement de plaques et permettant le dépôt sur deux zones des flancs simultanément.

Le ou les supports peuvent être montés mobiles en rotation dans l'enceinte afin de pouvoir réaliser successivement des dépôts sur plusieurs zones des flancs des plaques.

L'un des objets de la présent demande est alors un dispositif de dépôt chimique en phase vapeur assisté par plasma sur des bords de plaques, comportant une enceinte munie d'une ouverture, une porte configurée pour fermer l'ouverture, des moyens d'alimentation en gaz et des moyens d'évacuation connectés à l'enceinte, un générateur électrique, une structure de suspension d'au moins un premier empilement de plusieurs plaques à l'intérieur de l'enceinte, ladite structure étant configurée pour que les plaques soient alignées les unes par rapport aux autres, un circuit de connexion du premier empilement de plaques à une borne du générateur de sorte à former une première électrode, le dispositif comportant au moins une deuxième électrode disposée en regard d'une face du premier empilement et connectée à l'autre borne du générateur.

De préférence, la structure de suspension est configurée pour suspendre un deuxième empilement de plusieurs plaques dans l'enceinte, de sorte que les plaques du deuxième empilement soient alignées les unes par rapport aux autres, et de sorte que ledit deuxième empilement soit disposé à proximité du premier empilement et que les bords des plaques du premier empilement soient en partie en regard des bords des plaques du deuxième empilement, le deuxième empilement formant la deuxième électrode.

Dans un exemple de réalisation, le premier empilement présente au moins deux faces planes et dans lequel le dispositif comporte deux deuxième électrodes, chacune des deuxièmes électrodes étant disposées, lors de la mise en place du premier empilement dans l'enceinte, de sorte qu'elles soient chacune en vis-à-vis d'une face plane de l'empilement.

Dans un exemple avantageux, le dispositif de dépôt comporte des moyens pour modifier l'orientation angulaire du premier empilement autour de son axe et/ou du premier empilement et du deuxième empilement autour de leur axe.

Avantageusement, le dispositif de dépôt comporte des moyens pour modifier la distance entre le premier empilement et le ou les deuxièmes électrodes.

Dans un exemple de réalisation, la structure de suspension est configurée pour recevoir plusieurs empilements superposés le long de la direction verticale.

De manière avantageuse, la structure de suspension comporte une partie du circuit de connexion.

La structure de suspension peut être en partie fixée à la porte et ladite structure de suspension comporte un support par empilement, ledit support étant configuré pour être séparable de la porte.

Par exemple, le support est configuré pour recevoir des plaques de forme rectangulaire, ledit support comportant une plaque d'extrémité inférieure rectangulaire, une plaque d'extrémité supérieure rectangulaire, des tirants reliant les plaques d'extrémité supérieure et inférieure au niveau de deux côtés parallèles des plaques d'extrémité inférieure et supérieure rectangulaires, et des moyens de serrage des plaques les unes contre les autres, et des moyens pour aligner les plaques les unes par rapport aux autres.

Les moyens d'alignement mettent par exemple en œuvre les tirants qui assurent un alignement de deux bords de plaques parallèles, et les moyens d'alignement comportant par exemple également pour aligner les deux autres bords parallèles, une tige, un logement dans la plaque d'extrémité inférieure pour une extrémité longitudinale de la tige, et un logement pour la plaque d'extrémité supérieure pour l'autre extrémité longitudinale de la tige, les deux logements étant disposés de sorte que lorsque les extrémités de la tige sont dans leur logement, la tige est verticale, un bord de chaque plaque est destiné à venir en appui contre la tige et dans lequel ladite tige est amovible.

Selon une caractéristique additionnelle, chaque tirant comporte une extrémité longitudinale traversant l'une des plaques d'extrémité, ladite extrémité comportant un filetage avec lequel coopère un écrou, et dans lequel un ressort est interposé entre l'écrou et la plaque d'extrémité, l'ensemble tirant, écrou et ressort formant les moyens de serrage.

Un autre objet de la présente demande est une installation de dépôt comporte un dispositif de dépôt selon la présente demande et un robot de manutention configuré pour charger et décharger les plaques de la structure de suspension.

Un autre objet de la présente demande est un procédé de dépôt chimique en phase vapeur assisté par plasma sur des bords de plaques comportant :
- l'empilage des plaques de sorte qu'elles soient alignées les unes par rapport autres et forment un premier empilement,
- mise en place des plaques dans une enceinte de dépôt chimique en phase vapeur assisté par plasma de sorte que les bords des plaques soient en regard d'une électrode, et fermeture de l'enceinte,
- injection des gaz dans l'enceinte,
- polarisation du premier empilement et de l'électrode pour générer un plasma entre les bords des plaques et l'électrode.

Le procédé peut prévoir :
-- l'empilage d'autre plaques de sorte qu'elles soient alignées les unes par rapport autres et forment un deuxième empilement,
-- mise en place du deuxième empilement dans l'enceinte de sorte que les bords des plaques du deuxième empilement soient en face des bords de plaque du premier empilement,
-- polarisation du deuxième empilement.

Le procédé peut avantageusement comporter l'étape de rotation du premier empilement autour de son axe ou du premier empilement et du deuxième empilement autour de leur axe de sorte à effectuer le dépôt sur d'autres bords des plaques.

### BRÈVE DESCRIPTION DES DESSINS

La présente invention sera mieux comprise sur la base de la description qui va suivre et des dessins en annexe sur lesquels:
La figure 1 est une représentation schématique d'un dispositif de dépôt PECVD selon un exemple d'un premier mode de réalisation.
La figure 2 est une vue en perspective d'un exemple de support chargé avec des substrats pouvant être mis en œuvre dans le dispositif de la figure 1.
La figure 3 est une vue de dessus du support de la figure 2.
La figure 4 est une représentation schématique de dispositif de dépôt PECVD selon autre exemple du premier mode de réalisation.
La figure 5 est une vue de détail de la figure 4.
La figure 6 est une représentation schématique d'un dispositif de dépôt PECVD selon un exemple d'un deuxième mode de réalisation.
La figure 7 est une représentation en perspective du dispositif de la figure 6, l'enceinte étant ouverte.
La figure 8 est une représentation schématique d'un dispositif de dépôt PECVD selon un exemple du deuxième mode de réalisation.
La figure 9 est une représentation en perspective du dispositif de la figure 8, l'enceinte étant ouverte.
La figure 10 est une représentation en perspective d'un dispositif de dépôt selon un autre exemple selon le deuxième mode de réalisation,
La figure 11 représente le dispositif de la figure 10 avec un dispositif de chargement et de déchargement.

### EXPOSÉ DÉTAILLÉ DE MODES DE RÉALISATION PARTICULIERS

Le dispositif de dépôt PECVD selon l'invention est particulièrement adapté au dépôt sur les flancs des cellules photovoltaïques, mais le dispositif selon l'invention peut s'appliquer au dépôt sur les flancs de plaques utilisées dans d'autres domaines techniques.

Dans la description qui va suivre, nous utiliserons les termes « plaque » et « substrat » pour désigner les objets sur les flancs desquels on souhaite faire le dépôt.

Les plaques sont généralement en forme de quadrilatère, de préférence en forme de rectangle ou de carré. Mais l'invention s'applique à toute forme de plaque.

La description portera plus particulièrement sur un dispositif de dépôt pour plaque rectangulaire ou carrée. Les plaques comportent deux faces et quatre bords latéraux ou flancs. On peut souhaiter faire le dépôt sur les quatre bords ou sur deux bords, de préférence deux bords parallèles.

Le dispositif est particulièrement adapté pour effectuer le dépôt sur un bord de chaque plaque ou deux bords de chaque plaque simultanément. Dans la suite de la description, le ou les bords sur lequel lesquels le dépôt va avoir lieu est ou sont désignés « bords de dépôt », et les autres bords, « bords masqués ».

Le dispositif selon l'invention effectue le dépôt sur des empilements de plaques. Les plaques sont empilées verticalement de sorte que les plaques masquent les faces de la plaque située entre elles et que seuls les bords soient accessibles pour le dépôt.

On entend par « plaques alignées», un empilement de plaques, dont les bords à l'aplomb les uns des autres sont situés dans des plans. Les plans sont par exemple verticaux. La distance entre les bords de deux plaques successives projetés sur un même plan est de préférence comprise entre ± 0,05 mm.

Dans le cas de plaques rectangulaires ou carrés, l'empilement comporte quatre faces, chacune contenue dans un plan. Le dépôt aura lieu sur toute une face de l'empilement. Dans la suite de la description, la ou les faces de l'empilement sur laquelle ou lesquelles le dépôt va avoir lieu est ou sont désignée(s) « face de dépôt » ou « faces de dépôt », et les autres faces « faces masquées ».

Dans la description les plaques sont horizontales dans l'enceinte et les faces de dépôt sont verticales. Un dispositif dans lequel les faces de dépôts sont à l'horizontal voire inclinées par rapport à la verticale ne sort pas du cadre de la présente invention.

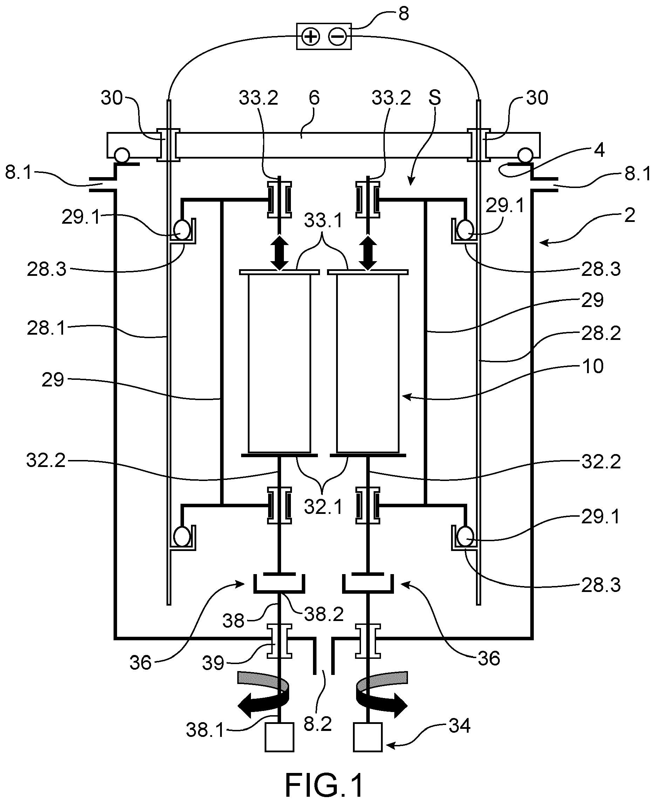

Sur la figure 1, on peut voir un exemple d'un dispositif de dépôt PECVD selon un premier mode de réalisation.

Le dispositif D1 comporte une enceinte 2 munie d'une ouverture supérieure 4 fermée de manière étanche par une porte 6.

Le dispositif comporte également des connexions fluidiques 8.1 d'alimentation pour amener les gaz formant le plasma et effectuer le dépôt, et des connexions fluidiques 8.2 d'évacuation des gaz après la phase de dépôt. De préférence l'alimentation se fait par le haut et l'évacuation se fait par le bas assurant au gaz de traverser l'enceinte.

Le dispositif comporte une structure de suspension S des plaques dans l'enceinte. Dans cet exemple, la structure de suspension comporte deux supports de plaques 10.

Les deux supports 10 sont disposés l'un à côté de l'autre.

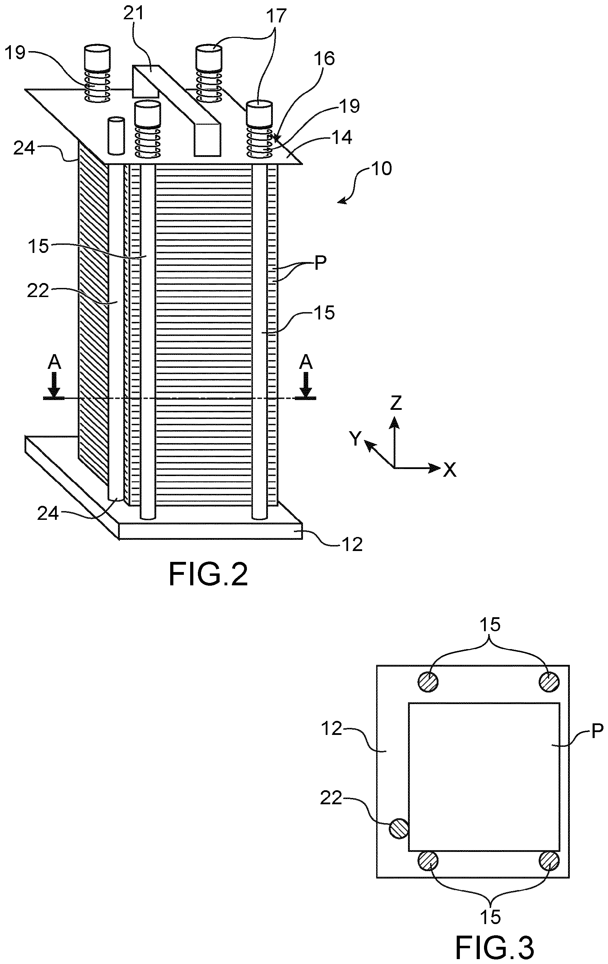

Sur la figure 2, on peut voir un exemple de support de plaques 10 chargé de plaques.

Le support 10 s'étend selon un axe longitudinal Z est destiné à être orienté verticalement dans l'exemple représenté. Il comporte une plaque d'extrémité inférieure 12 et une plaque d'extrémité supérieure 14 reliées par des tirants 15, quatre tirants dans l'exemple représenté. Les plaques P empilées les unes sur les autres sont déposées sur la plaque d'extrémité inférieure entre les tirants, la plaque d'extrémité supérieure est disposée sur l'empilement. Le support comporte également des moyens 16 permettent d'appliquer un effort de serrage sur les plaques par l'intermédiaire des plaques d'extrémité 12 et 14.

Dans l'exemple représenté, les moyens de serrage 16 comportent des écrous 17 coopérant avec des extrémités filetées des tirants 15 traversant la plaque d'extrémité supérieure. Avantageusement un moyen élastique par exemple un ressort hélicoïdal 19, est monté en compression entre l'écrou et la plaque d'extrémité supérieure autour du tirant 15, permettant d'exercer un effort de serrage important tout en maîtrisant celui-ci et évitant d'endommager les plaques.

L'effort de serrage est suffisant pour permettre le déplacement de l'empilement sans risque d'une plaque s'échappe et assurant un contact intime entre les faces des plaques pour éviter l'infiltration de gaz entre les plaques qui pourrait risquer un redépôt sur les faces.

La plaque supérieure comporte dans cet exemple une poignée de manutention 21 permettant de déplacer le support 10 chargé des plaques pour exemple pour le charger dans l'enceinte et éventuellement pour l'accrocher dans l'enceinte.

Dans cet exemple, les bords de dépôt sont parallèles. Les deux faces masquées de l'empilement sont disposées de sorte à être situées en regard des tirants 15, les deux autres faces de dépôt ne sont masquées par aucun objet pour permettre le dépôt sur celles-ci. La distance entre deux tirants 15 situés de part et d'autre de l'empilement est égale à la distance entre les deux faces masquées, ainsi lors de l'empilement des plaques entre les tirants, un alignement des bords masqués des plaques a lieu.

Le support comporte également des moyens 20 pour assurer un alignement des bords de dépôt les uns par rapport aux autres, de sorte que les plaques masquent mutuellement leurs faces et que seuls les bords de dépôt soient accessibles lors du dépôt.

Dans l'exemple représenté, les moyens 20 comportent une tige 22 et des logements 24 dans les plaques d'extrémité 12 et 14 disposées de sorte que, lorsque la tige 22 est montée dans les logements 24, la tige 22 soit parallèle à l'axe de l'empilement. L'axe de l'empilement est vertical et la tige 22 est verticale. En outre les logements sont disposés de sorte que la tige soit en regard d'un bord de dépôt des plaques.

La tige 22 est mise en place dans les logements 24 avant d'empiler les plaques. Ensuite lors de l'empilage des plaques, un bord de dépôt de chaque plaque est mis en appui contre la tige 22, et les bords masqués en appui contre les tirants. Ainsi les plaques sont alignées les unes par rapport aux autres et les faces de chaque plaque sont masquées par les plaques inférieure et supérieure.

Pour les plaques situées aux extrémités supérieure et inférieure de l'empilement, leur face orientée vers l'extérieur de l'empilement est masquée par les plaques d'extrémité du support.

La tige 22 est retirée avant le dépôt PECVD pour éviter de masquer une partie des bords de dépôt.

Les deux supports chargés de plaques sont disposés l'un par rapport à l'autre dans l'enceinte, de sorte qu'une face de dépôt d'un empilement soit en regard, et avantageusement parallèle, à une face de dépôt de l'autre empilement. Les empilements de plaques servent d'électrodes l'un pour l'autre et un plasma est généré entre les faces de dépôt des deux empilements.

Le dispositif comporte également au moins un générateur électrique 8 pour alimenter électriquement chacun des empilements. Le générateur 8 est par exemple un générateur de tension radiofréquence ou un générateur de courant alternatif. Le dispositif de dépôt comporte également un circuit de connexion électrique 28 entre les bornes + et - du générateur et les empilements.

De manière avantageuse, une partie du circuit de connexion électrique 28 est intégrée à la structure de suspension.

Le circuit de connexion comporte deux tiges ou cannes conductrices électrique 28.1, 28.2, chacune reliée à une borne du générateur, et des moyens de connexion des cannes aux empilements. Dans cet exemple, les cannes traversent la porte 6. Des traversées 30 en matériau isolant électrique, par exemple en alumine, isolent les cannes de la porte.

En outre les plaques d'extrémités et les tirants des supports sont conducteurs électriques. La polarisation de chacun des empilements est réalisée par l'intermédiaire des supports.

La structure de suspension S est telle qu'elle permet une connexion automatique des supports aux cannes 28.1, 28.2 lors de la mise en place des supports dans l'enceinte. Par exemple, la structure comporte des châssis 29 enserrant chacun un empilement, le châssis 29 comprenant des éléments de connexion 29.1 venant se placer dans des logements 28.3 des cannes lors d'insertion des supports dans l'enceinte.

De manière très avantageuse, la structure de suspension S permet de faire pivoter chaque empilement autour de son axe d'un angle de 180°, ce qui permet de mettre en regard les deux autres faces de dépôt de l'empilement, et ainsi de réaliser le dépôt sur les deux faces de dépôt de chaque empilement sans avoir à retirer les empilements de l'enceinte.

Par exemple, chaque châssis comporte des plaques inférieure 32.1 et supérieure 33.1 et des arbres inférieur 32.2 et supérieur 33.2 fixés aux plaques inférieure et supérieure respectivement. Les supports sont reçus entre les plaques inférieure et supérieure de sorte que les arbres inférieur et supérieur soient coaxiaux à l'axe de l'empilement. Les arbres sont reçus dans des paliers portés par les châssis 29 permettant leur rotation.

En outre, le dispositif comporte des moyens 34 pour mettre en rotation chaque support. Dans l'exemple représenté, les moyens 34 sont situés à l'extérieur de l'enceinte et des moyens d'accouplement 36 de l'arbre inférieur 32.2, 33.2 et des moyens 34 sont prévus dans l'enceinte. Les moyens 34 comportent par exemple un moteur électrique ou une manivelle.

Les moyens d'accouplement 36 comportent un arbre 38 traversant le fond de l'enceinte de manière étanche, par exemple au moyen d'un joint tournant 39, L'arbre 38 comporte une extrémité 38.1 à l'extérieur de l'enceinte coopérant avec les moyens 34 et une extrémité 38.2 à l'intérieur de l'enceinte coopérant avec l'arbre inférieur 32, de sorte à être solidaire en rotation et permettre un écartement axial de l'arbre inférieur 3.2 et de l'extrémité 38.2, afin de permettre la mise en place et le retrait du support dans l'enceinte.

Le fonctionnement du dispositif de dépôt est le suivant.

Chaque support 10 est relié à un châssis 29. Les plaques, par exemple des substrats en silicium, sont ensuite empilées sur une plaque inférieure du support 10, les bords masqués en appui contre les tirants et un bord de dépôt en appui contre la tige 22. Lorsque le nombre de plaques souhaité a été empilé un effort de serrage est appliqué entre la plaque inférieure et la plaque supérieure du support 10 sur l'empilement via les tirants. Les substrats sont alignés.

Lors de la mise en place des empilements dans l'enceinte, les éléments de connexion des châssis pénètrent dans les logements des cannes, chaque empilement est alors automatiquement relié à une borne du générateur, et l'arbre inférieur s'accouple mécaniquement avec l'arbre traversant de manière automatique.

Les deux empilements sont alors positionnés l'un par rapport à l'autre de sorte que deux faces de dépôt se fassent face.

L'enceinte est fermée de manière étanche, les gaz sont injectés dans l'enceinte les deux empilements sont polarisés. Une excitation par décharge capacitive est réalisée en appliquant un courant alternatif ou radiofréquence entre les 2 empilements de plaquettes. Le plasma est créé à partir d'un ou plusieurs gaz par une décharge électrique générée à partir de sources radiofréquences, par exemple la fréquence du générateur RF est comprise entre 40 kHz à 440 kHz, et la tension entre deux électrodes est comprise entre 50 Volts et 500 Volts.

Le plasma est généré entre les deux empilements.

Le gaz étant injecté par le haut du tube, des extinctions et allumages du plasma dans le temps permettent d'obtenir une bonne homogénéité du dépôt le long de l'empilement.

Par exemple, une couche de nitrure de silicium (SiNx) peut être utilisée pour réaliser les couches de passivation déposées sur les bords des cellules en utilisant un mélange de gaz silane (SiH₄) et ammoniac (NH₃). Selon un autre exemple, une couche d'oxyde d'aluminium peut également être utilisée en réalisant un mélange gazeux de protoxyde d'azote (N₂O) et de Triméthylaluminium (TMA).

Lorsque le dépôt sur ces faces de dépôt est terminé, l'alimentation électrique est coupée.

Les deux empilements sont pivotés d'un angle de 180° autour de leur axe, de sorte à mettre en regard les deux autres faces de dépôt.

Les deux empilements sont à nouveau polarisés, les gaz sont injectés dans l'enceinte. Ils forment des électrodes et un plasma apparaît entre les deux faces de dépôt. Le matériau se dépose sur les bords de dépôt des plaques.

L'alimentation électrique est coupée et les empilements peuvent être sortis de l'enceinte.

En variante, le dispositif ne comporte pas de moyens pour faire pivoter les empilements, les empilements sont alors retirés de l'enceinte, pivoter de 180° autour de leur axe et remis en place dans l'enceinte.

Si l'on souhaite effectuer des dépôts sur les bords masqués, les plaques sont retirées des supports et pivoter de 90° de sorte à placer les bords sur lesquels le dépôt a eu lieu contre les tirants.

Il est à noter que dans le domaine photovoltaïque, les cellules sont généralement découpées de sorte que seuls deux bords opposés requièrent un dépôt.

La mise en œuvre de support de plaques séparables de la porte permet un chargement/déchargement des plaques en temps masqué. En effet, le support après dépôt peut être déchargé à l'extérieur de l'enceinte, pendant qu'un cycle de dépôt est appliqué à un autre empilement de plaques. La productivité est augmentée.

En variante, le dispositif de dépôt comporte une structure de suspension entièrement fixée à la porte, et les plaques sont directement empilées sur la structure. Le chargement et le déchargement ne peuvent alors se faire en temps masqué.

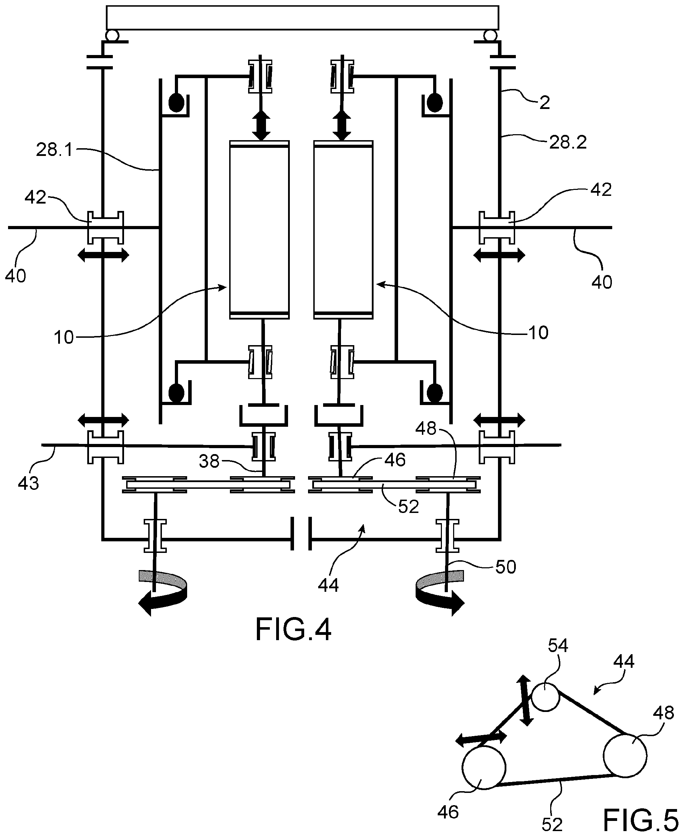

Sur la figure 4, on peut voir un autre exemple de réalisation selon le premier mode de réalisation. Dans cet exemple, la distance entre les faces de dépôt des deux empilements est modifiable, i.e. la distance entre les électrodes est modifiable.

Dans la présente demande, la distance entre les empilements et la distance entre les faces de dépôt désignent la même distance qui est la distance entre les deux électrodes.

La modification de la distance entre les électrodes permet de réduire cette distance et de créer un plasma avec une puissance réduite.

En effet, la possibilité de rotation des empilements autour de leur axe impose une distance minimale entre les empilements. Dans cet exemple, on prévoit avantageusement de pouvoir écarter les deux empilements l'un de l'autre pour pouvoir les faire pivoter et ensuite les rapprocher pour le dépôt.

Le dispositif de la figure 4 diffère de celui de la figure 1 par le fait que les cannes d'alimentation 28.1, 28.2 sont montées dans l'enceinte de manière à pouvoir être coulissées horizontalement. Pour cela, chaque canne est reliée au générateur par un connecteur 40 s'étendant latéralement par rapport à la direction de la canne et traverse la paroi latérale de l'enceinte via une traversée étanche 42. Les traversées 42 sont en matériau isolant électrique pour isoler les connecteurs de la paroi métallique de l'enceinte. En variante, le connecteur est uniquement un élément mécanique pour déplacer la canne, par exemple en matériau isolant électrique et la canne est reliée au générateur par un connecteur souple qui suit le déplacement de la canne.

Les moyens d'accouplement sont également montés dans l'enceinte de sorte à pouvoir être coulissés horizontalement. Dans l'exemple représenté, un palier recevant l'arbre inférieur est supporté par un bras 43 monté coulissant de manière étanche à travers la paroi latérale de l'enceinte et permettant de déplacer latéralement les moyens d'accouplement.

En outre le dispositif comporte des moyens de transmission 44 (figure 5) du mouvement de rotation entre les moyens 34 et les moyens d'accouplement tout en permettant le déplacement transversal des empilements.

Dans l'exemple les moyens de transmission 44 comportent une poulie 46 en prise directe avec l'arbre 43 des moyens d'accouplement, une poulie 48 en prise directe avec un arbre 50 des moyens 34 traversant le fond de l'enceinte, une courroie 52 enroulée autour des poulies. Avantageusement un tendeur 54 de la courroie 52 est mis en œuvre pour maintenir la courroie 52 en tension, quelle que soit la position relative de l'arbre des moyens 34 et de l'arbre 38.

Le fonctionnement de ce dispositif va maintenant être décrit.

Les cannes et les moyens d'accouplement sont positionnés de sorte que la distance entre les empilements est la distance pour effectuer le dépôt.

Les empilements sont mis en place dans la structure de suspension, le dépôt sur les deux faces de dépôt en regard a lieu.

On souhaite effectuer le dépôt sur deux autres faces des empilements.

Pour cela, on agit sur les cannes et sur les moyens d'accouplement pour déplacer latéralement les empilements en éloignement l'un de l'autre. Ils sont déplacer jusqu'à ce qu'ils soient suffisamment éloignés pour permettre leur rotation. Du fait des poulies, l'arbre inférieur 33.2 peut être déplacé transversalement et du fait du tendeur la tension de la courroie est maintenue.

Les empilements sont ensuite pivotés de 90° ou de 180°.

Les empilements sont rapprochés l'un de l'autre de sorte à être séparés par la distance de dépôt. Le dépôt peut ensuite avoir lieu.

Ces étapes peuvent être répétées pour effectuer un dépôt sur les quatre faces.

A titre d'exemple, la distance entre les deux faces de dépôt des empilements peut varier entre 8 mm et 30 mm.

Dans l'exemple représenté, le dispositif est configuré pour que les deux empilements puissent être déplacés. En variante, un seul empilement peut être déplacé d'une distance suffisante pour permettre la rotation.

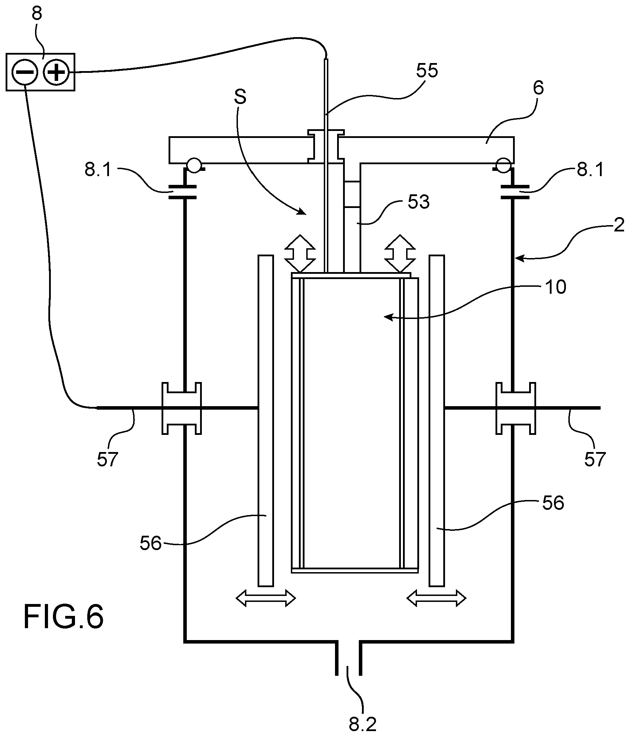

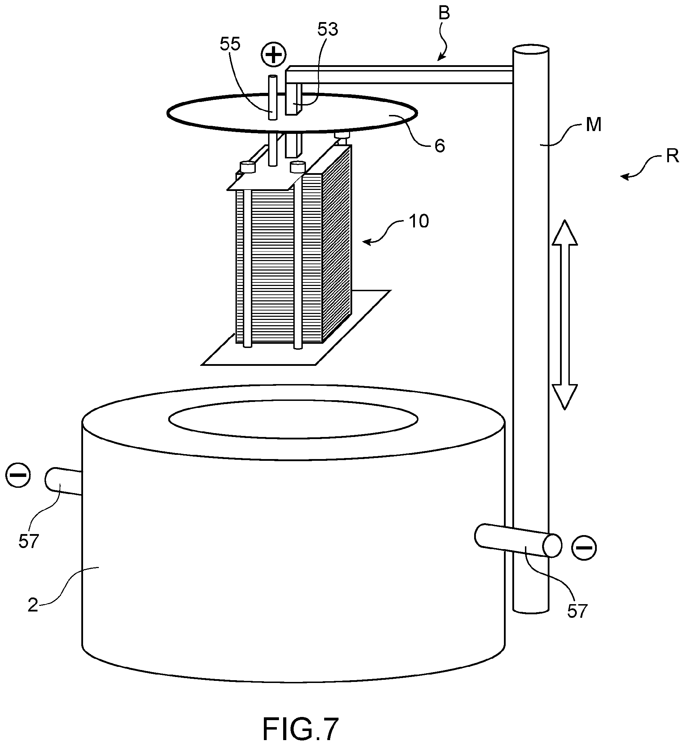

Sur les figures 6 et 7, on peut voir un exemple de dispositif de dépôt PECVD selon un deuxième mode de réalisation.

Dans ce deuxième mode de réalisation, le dispositif de dépôt comporte un seul empilement formant électrode et des électrodes dédiées sont prévues pour effectuer le dépôt.

L'empilement de plaques est logé dans un support tel que représenté sur les figure 2 et 3. Il est suspendu à la porte par exemple au moyen d'un arbre 53, dont au moins une partie est en matériau isolant électrique de sorte que son axe soit vertical. Un connecteur électrique 55 est prévu pour relier l'empilement à une borne du générateur. Dans cet exemple, la connexion électrique traverse la porte. On peut avantageusement prévoir une connexion automatique entre le connecteur et le support, en particulier la plaque d'extrémité supérieure lors de la fixation du support sur l'arbre 53.

Dans cet exemple, la porte est solidaire d'un bras de manutention B d'un robot R. Le robot est une potence à laquelle est suspendue la porte. La potence comporte un mât M. Au moins le bras B est mobile verticalement le long du mât. Eventuellement le mât est mobile en rotation autour de son axe.

Le dispositif comporte également deux électrodes 56 disposées parallèlement l'une par rapport à l'autre et délimitant un logement pour l'empilement de sorte que chaque électrode soit en regard d'une face de dépôt de l'empilement.

Dans cet exemple, les électrodes 56 sont montées mobiles latéralement de sorte à pouvoir être éloignées ou rapprochées des faces de l'empilement. Le montage mobile des électrodes par des connecteurs 57 est similaire à celui des cannes du dispositif de la figure 1.

La distance entre l'empilement et les électrodes et la distance entre les faces de dépôt de l'empilement et les électrodes sont synonymes.

Le fonctionnement de ce dispositif est le suivant.

Les plaques sont chargées dans un support, puis le support est fixé à l'arbre 53 solidaire de la porte et le connecteur 55 est relié à la plaque d'extrémité supérieure.

L'empilement est inséré entre les électrodes 56.

La distance entre les électrodes et les faces de dépôt de l'empilement est ajustée. Les gaz sont injectés dans l'enceinte et les électrodes 56 et l'empilement sont polarisés. L'empilement forme une électrode. Un plasma apparaît entre les électrodes et les faces de dépôt de l'empilement en regard.

Lorsque la phase de dépôt est terminée, l'empilement est retiré de l'enceinte. Si un dépôt sur les autres bords des plaques est requis, celles-ci sont retirées du support, pivotées de 90° de sorte à disposer les bords ayant subis le dépôt en regard des tirants. Puis l'empilement est remis en place dans l'enceinte pour une nouvelle phase de dépôt.

En variante, une seule électrode est mise en œuvre.

En variante, le dispositif de dépôt comporte quatre électrodes pour pouvoir déposer simultanément sur les 4 faces de l'empilement. Le support est adapté pour ne pas masquer les faces de l'empilement.

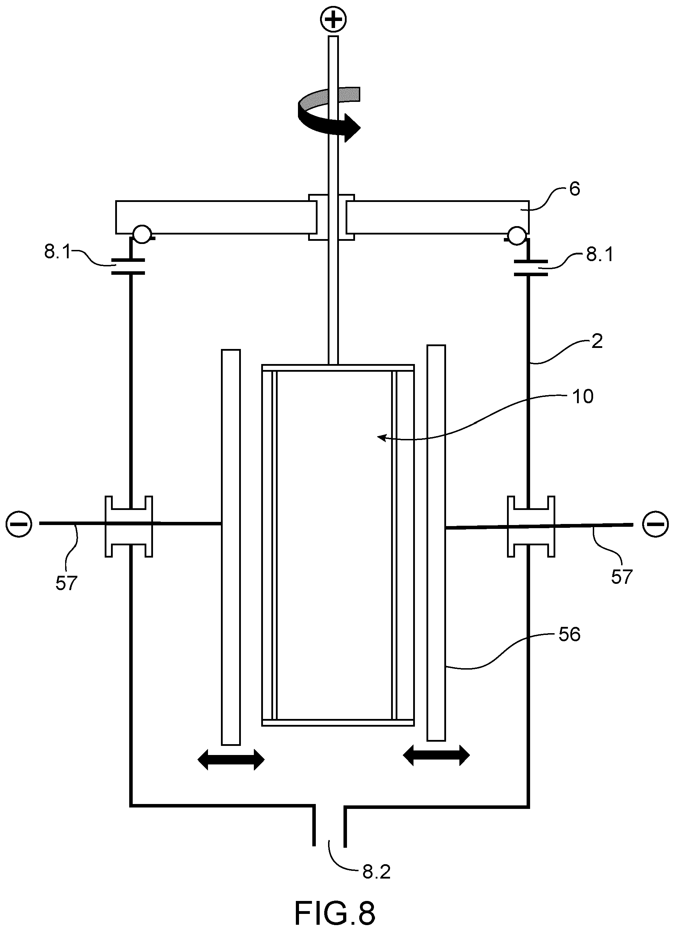

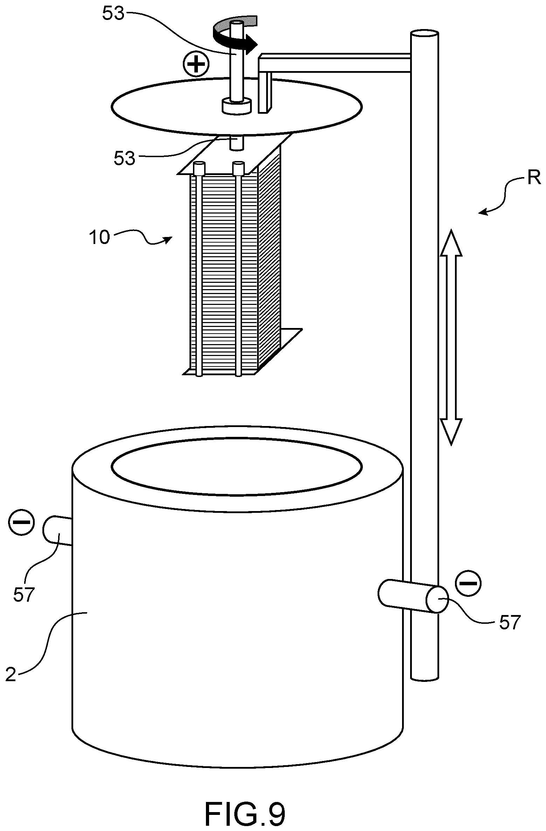

Sur les figures 8 et 9, on peut voir un autre exemple de dispositif de dépôt PECVD selon le deuxième mode de réalisation, dans lequel le support est supporté par la porte de sorte à pouvoir pivoter.

Dans cet exemple, le bras 53 forme une canne de polarisation et est monté à travers la porte à travers un joint tournant pour permettre sa rotation dans la porte, et faire pivoter l'empilement. Ce dispositif est particulièrement intéressant lorsqu'un support permettant un dépôt sur les quatre faces est mis en œuvre.

Le fonctionnement de ce dispositif est proche de celui de la figure 6.

Après le dépôt sur les deux faces de dépôt, les électrodes sont écartées de l'empilement. L'empilement est pivoté de 90°, les électrodes sont remises à une distance de dépôt de l'empilement, et le dépôt peut avoir lieu sur les deux autres faces de dépôt.

En variante, le dispositif comporte une seule électrode. L'empilement est alors pivoté de 180° pour effectuer le dépôt sur la face opposée de l'empilement.

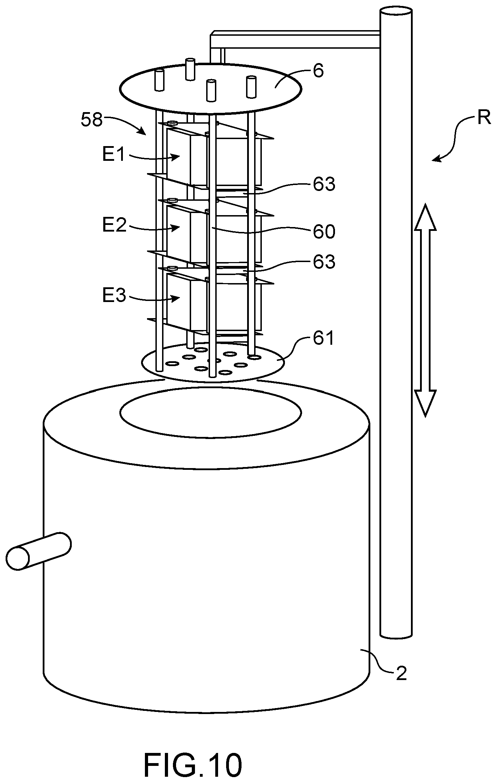

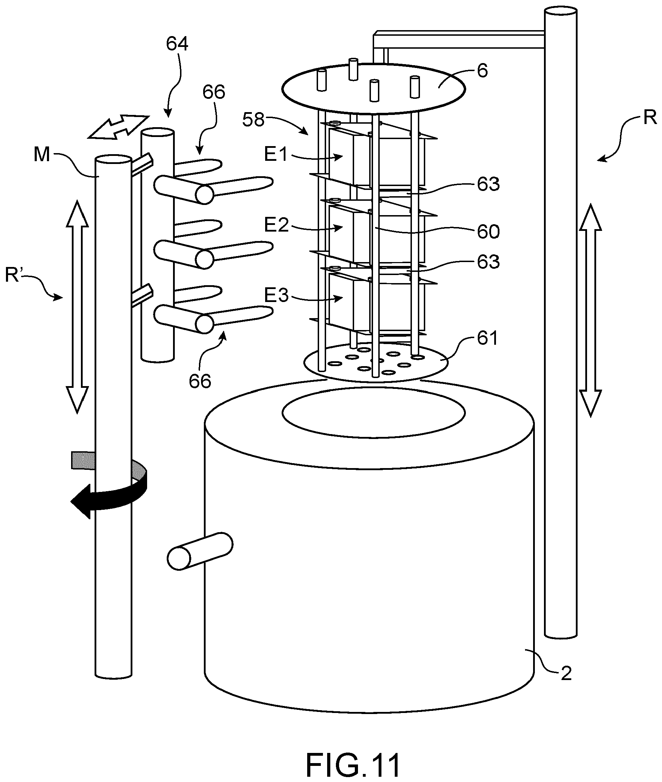

Sur les figures 10 et 11, on peut voir un autre exemple de structure de suspension des plaques.

Dans cet exemple, les plaques sont réparties en plusieurs empilements E1, E2, E3, les empilements étant logés dans un bâti 58 de la structure. Le nombre de plaques par empilement est généralement réduit par rapport à celui des empilements mise en œuvre dans les dispositifs de figures 1, 5, 6- 9

Le bâti 58 comporte quatre montants 60 s'étendant verticalement entre une plaque de base 61 et la porte 6. Les montants sont disposés les uns par rapport aux autres de sorte à délimiter un logement permettant de loger des empilements.

De traverses horizontales 63 s'étendent entre les montants 60 de deux paires de montants, de sorte à former deux échelles en vis-à-vis. Les traverses 63 sont fixées aux montants 60 de sorte à faire saillie dans l'espace délimité entre les quatre montants, formant ainsi des supports pour les empilements introduits dans les montants.

Le bâti comporte alors deux faces ouvertes en vis-à-vis et deux faces en vis-à-vis partiellement obturées par les traverses 63.

Le bâti sert également avantageusement de moyens de polarisation des empilements. Les montants et les traverses sont en matériau conducteur métallique et sont reliés au générateur à travers la porte.

En variante, une connexion individuelle de chaque empilement est envisageable, le bâti étant isolant électrique, néanmoins une telle configuration est plus complexe.

Dans l'exemple représenté, les plaques de différents empilements ont les mêmes dimensions. Mais le dispositif peut être adapté pour recevoir des empilements, chacun ayant des plaques de dimensions différentes de celles des autres empilements.

Sur la figure 11, on peut voir un robot de manutention R' spécialement adapté au chargement et déchargement des empilements dans le bâti 58.

Le robot R' comporte un mât M mobile en rotation autour de son axe et un chariot de chargement-déchargement 64 monté sur le mât mobile en translation le long de l'axe du mât et horizontalement en rapprochement et en éloignement de l'axe du mât. Le chariot 64 comporte des fourches 66 à deux dents s'étendant horizontalement et dont l'écartement inter-dents correspond à la dimension transversale d'un empilement, de sorte que l'empilement puisse se loger entre les deux dents d'une fourche 66 et les deux dents viennent en appui contre la face inférieure d'une plaque d'extrémité supérieure d'un empilement.

Dans l'exemple représenté, le bâti 58 peut recevoir trois empilements et le robot comporte trois fourches 66 permettant avantageusement de charger tous les empilements simultanément.

Un exemple de chargement va maintenant être décrit.

Trois empilement tels que représentés sur la figure 2 sont préparés.

Ils sont ensuite chargés chacun sur une fourche, la plaque d'extrémité supérieure de chaque empilement reposant sur une fourche.

Avantageusement, un bâti de stockage similaire au bâti 58 est prévu dans la salle de préparation des empilements et les empilements sont chargés sur celui-ci, le robot peut alors simultanément prendre les empilements disposés sur le bâti de stockage.

Le robot pivote autour de son axe et place les empilements de sorte à être regard de l'une des faces ouvertes du bâti, le chariot se déplace alors horizontalement pour introduire les empilements dans le bâti et de sorte que chaque plaque d'extrémité supérieure soit située au-dessus d'une paire de traverses 63. Ensuite le chariot 64 descend jusqu'à ce que les plaques d'extrémité supérieures entrent en contact avec les traverses 63 et reposent sur celles-ci. Le chariot 64 se déplace horizontalement en éloignement du bâti, les fourches 66 sortant du bâti. La porte peut s'abaisser pour fermer le dispositif. La phase de dépôt peut avoir lieu.

La structure de suspension des figures 10 et 11 peut être mise en œuvre dans un dispositif selon la premier mode de réalisation, dans lequel lesquels deux empilements sont juxtaposés et servent mutuellement de deuxièmes électrodes, en polarisant les empilements de manière opposée.

Les structures de suspension décrites sont des exemples de réalisation non limitatifs et toute structure permettant de suspendre un ou des empilements dans l'enceinte selon une direction telle qu'au moins une face du ou des empilements soit en regard d'une électrode en vue de générer un plasma entre la face de l'empilement et l'électrode entre dans le cadre de la présente invention. Tout autre moyen permettant de déplacer les empilements en rotation et tout autre moyen permettant de déplacer le ou les empilements et le ou les électrodes les uns par rapport aux autres entre dans le cadre de la présente invention.

Selon une variante, le dispositif de dépôt combine le dispositif de la figure 1 et le dispositif de la figure 6, i.e. le dispositif accueille deux empilements disposés l'un à côté de l'autre et comporte des électrodes en regard chacune d'une face de l'empilement. Ce dispositif permet de réaliser des dépôts sur deux faces de chaque empilement simultanément.

## Revendications

1. Dispositif de dépôt chimique en phase vapeur assisté par plasma sur des bords de plaques, comportant une enceinte (2) munie d'une ouverture, une porte (6) configurée pour fermer l'ouverture, des moyens (8.1) d'alimentation en gaz et des moyens d'évacuation (8.2) connectés à l'enceinte, un générateur électrique (8), une structure de suspension (S) d'au moins un premier empilement de plusieurs plaques à l'intérieur de l'enceinte, ladite structure (S) étant configurée pour que les plaques (P) soient alignées les unes par rapport aux autres, un circuit de connexion du premier empilement de plaques à une borne du générateur (8) de sorte à former une première électrode, le dispositif comportant au moins une deuxième électrode (56) disposée en regard d'une face du premier empilement et connectée à l'autre borne du générateur (8) et des moyens pour modifier la distance entre le premier empilement et la ou les deuxièmes électrodes.

2. Dispositif de dépôt selon la revendication 1, configuré pour réaliser un dépôt uniquement sur les bords de plaques, lesdites plaques étant rectangulaires, et dans lequel le dispositif comporte également des moyens configurés pour modifier l'orientation angulaire du premier empilement autour de son axe de sorte que :
- lors d'une première phase, le dépôt ait lieu sur une face du premier empilement,
- lors d'une deuxième phase, les moyens pour modifier l'orientation angulaire du premier empilement autour de son axe sont commandés pour pivoter le premier empilement et mettre une autre face du premier empilement en regard de la deuxième électrode,
- lors d'une troisième phase, le dépôt ait lieu sur ladite autre face du premier empilement.

3. Dispositif de dépôt chimique en phase vapeur assisté par plasma selon la revendication 1, configuré pour réaliser un dépôt uniquement sur les bords de plaques, lesdites plaques étant rectangulaires, dans lequel la structure de suspension (S) est configurée pour supporter un une deuxième empilement de plusieurs plaques, ladite structure (S) étant configurée pour que les plaques (P) du deuxième empilement soient alignées les unes par rapport aux autres formant des faces latérales planes, et de sorte que le premier empilement et le deuxième empilement ont des faces latérales planes au moins en partie en regard, dans lequel le dispositif de dépôt comporte également un circuit de connexion du deuxième empilement de plaques à une autre borne du générateur (8) de sorte à former une deuxième électrode, et des moyens configurés pour modifier l'orientation angulaire du premier empilement autour de son axe et l'orientation angulaire du premier empilement autour de son axe de sorte que :
- lors d'une première phase, le dépôt ait lieu sur les faces latérales planes en regard du premier empilement et du deuxième empilement,
- lors d'une deuxième phase, les moyens pour modifier l'orientation angulaire du premier empilement autour de son axe et du deuxième empilement autour de son axe sont commandés pour pivoter le premier empilement et le deuxième empilement et mettre deux autres faces latérales du premier empilement et du deuxième empilement en regard,
- lors d'une troisième phase, le dépôt ait lieu sur lesdites deux autres faces planes du premier empilement et du deuxième empilement.

4. Dispositif de dépôt selon la revendication 1, 2 ou 3, dans lequel le premier empilement et/ou le deuxième empilement présente(nt) au moins deux faces planes et dans lequel le dispositif comporte deux autres électrodes, chacune des autres électrodes étant disposées, lors de la mise en place du premier empilement et/ou du deuxième empilement dans l'enceinte, de sorte qu'elles soient chacune en vis-à-vis d'une face plane d'un des premier et deuxième empilements.

5. Dispositif de dépôt selon l'une des revendications 1 à 4, dans lequel la structure de suspension est configurée pour recevoir plusieurs empilements superposés le long de la direction verticale.

6. Dispositif de dépôt selon l'une des revendications 1 à 5, dans lequel la structure de suspension comporte une partie du ou des circuits de connexion.

7. Dispositif de dépôt selon l'une des revendications 1 à 6, dans lequel la structure de suspension est en partie fixée à la porte et ladite structure de suspension comporte un support par empilement, ledit support étant configuré pour être séparable de la porte.

8. Dispositif de dépôt selon la revendication précédente, dans lequel le support (10) est configuré pour recevoir des plaques de forme rectangulaire, ledit support comportant une plaque d'extrémité inférieure rectangulaire, une plaque d'extrémité supérieure rectangulaire, des tirants reliant les plaques d'extrémité supérieure et inférieure au niveau de deux côtés parallèles des plaques d'extrémité inférieure et supérieure rectangulaires, et des moyens de serrage des plaques les unes contre les autres, et des moyens pour aligner les plaques les unes par rapport aux autres.

9. Dispositif de dépôt selon la revendication précédente, dans lequel les moyens d'alignement mettent en œuvre les tirants qui assurent un alignement de deux bords de plaques parallèles, lesdits moyens d'alignement comportant également pour aligner les deux autres bords parallèles, une tige, un logement dans la plaque d'extrémité inférieure pour une extrémité longitudinale de la tige, et un logement pour la plaque d'extrémité supérieure pour l'autre extrémité longitudinale de la tige, les deux logements étant disposés de sorte que lorsque les extrémités de la tige sont dans leur logement, la tige est verticale, un bord de chaque plaque est destiné à venir en appui contre la tige et dans lequel ladite tige est amovible.

10. Dispositif de dépôt selon la revendication 8 ou 9, dans lequel chaque tirant comporte une extrémité longitudinale traversant l'une des plaques d'extrémité, ladite extrémité comportant un filetage avec lequel coopère un écrou, et dans lequel un ressort est interposé entre l'écrou et la plaque d'extrémité, l'ensemble tirant, écrou et ressort formant les moyens de serrage.

11. Installation de dépôt comporte un dispositif de dépôt selon l'une des revendications précédentes et un robot de manutention configuré pour charger et décharger les plaques de la structure de suspension.

12. Procédé de dépôt chimique en phase vapeur assisté par plasma sur des bords de plaques mettant en œuvre un dispositif de dépôt chimique en phase vapeur assisté par plasma selon l'une des revendications 1 à 10, comportant :
- l'empilage des plaques de sorte qu'elles soient alignées les unes par rapport autres et forment un premier empilement,
- mise en place des plaques dans une enceinte de dépôt chimique en phase vapeur assisté par plasma de sorte que les bords des plaques soient en regard d'une électrode, et fermeture de l'enceinte,
- injection des gaz dans l'enceinte,
- polarisation du premier empilement et de l'électrode pour générer un plasma entre les bords des plaques et l'électrode.

13. Procédé de dépôt selon la revendication précédente en combinaison avec la revendication 2 ou 3, comportant l'empilage d'autre plaques de sorte qu'elles soient alignées les unes par rapport autres et forment un deuxième empilement,
- mise en place du deuxième empilement dans l'enceinte de sorte que les bords des plaques du deuxième empilement soient en face des bords de plaque du premier empilement,
- polarisation du deuxième empilement.

14. Procédé de dépôt selon la revendication 12 ou 13, comportant l'étape de rotation du premier empilement autour de son axe ou du premier empilement et du deuxième empilement autour de leur axe de sorte à effectuer le dépôt sur d'autres bords des plaques.
